Europäisches Patentamt

European Patent Office

Office européen des brevets

(11) Publication number: **0 310 351 B1**

# EUROPEAN PATENT SPECIFICATION

(45) Date of publication of patent specification: **14.07.93** (51) Int. Cl.⁵: **G11C 11/412**, H01L 27/07, H01L 27/092, H01L 27/11

(21) Application number: **88308978.1**

(22) Date of filing: **28.09.88**

(54) **Static memory using Schottky technology.**

(30) Priority: **30.09.87 US 102996**

(43) Date of publication of application:
**05.04.89 Bulletin 89/14**

(45) Publication of the grant of the patent:
**14.07.93 Bulletin 93/28**

(84) Designated Contracting States:
**DE FR GB NL**

(56) References cited:
**EP-A- 0 084 252**
**EP-A- 0 106 222**
**EP-A- 0 150 726**
**EP-A- 0 186 422**
**DE-A- 3 644 253**

(73) Proprietor: **TEXAS INSTRUMENTS INCORPO-
RATED**
**13500 North Central Expressway**
**Dallas Texas 75265(US)**

(72) Inventor: **Teng, Clarence Wan-Hsin**
**4301 Denver Drive**
**Plano Texas 75075(US)**

(74) Representative: **Abbott, David John et al**
**Abel & Imray Northumberland House 303-306**
**High Holborn**
**London, WC1V 7LH (GB)**

**Description**

TECHNICAL FIELD OF THE INVENTION

This invention pertains in general to semiconductor memory devices, more particularly to 4-transistor/2-resistor static random access memory structures and methods of forming the same.

BACKGROUND OF THE INVENTION

The current art for static random access memory (SRAM) cell design is mainly divided into two categories. Six-transistor (6-T) and four-transistors/two-resistors (4-T/2-R) cells. Because of its smaller area, the 4-T/2-R cell is more desirable in high density applications.

However, a major disadvantage for the 4-T/2-R SRAM has been its higher standby power consumption. The standby power requirement can be reduced by increasing the resistance in the memory cell structure. The resistance employed for large memories should be at least one gigaohm, which results in a transfer of approximately five milliwatts standby power for a one megabit SRAM. Using a resistance of 100 gigaohms, the standby power requirement is reduced to approximately 50 microwatts.

In order to fabricate such large resistances in the SRAM cell design, means other than the traditional resistor fabrication techniques using buried junction layers are required, because of the large area needed to produce sufficiently high resistances using the traditional techniques. A recent approach is to use undoped polysilicon to fabricate the resistors. However, the resistance of polysilicon is extremely sensitive to several factors such as grain size, thermal treatment after polysilicon deposition, and impurities intensionally and inadvertently introduced to the polysilicon material. The sensitivity to these factors impair the reproducibility of the polysilicon transistor, particularly for higher resistances. In fact, it is not uncommon to obtain a factor of five variation in resistance between polysilicon resistors. Hence, the polysilicon resistor technology is not appropriate for producing high resistance devices for use in the 4-T/2-R SRAM cell design where a degree of accuracy is required.

Thus, a need has arisen for a technology capable of producing high value resistors for an SRAM cell design, without increasing the cell area.

According to one aspect of the present invention there is provided a static memory cell comprising;

a pass transistor responsive to a word line signal through which the state of the memory cell is communicated with a bit line;

a latching circuit including loaded and cross-coupled first and second transistors for latching a data bit to be stored in the memory cell; and

characterised in that

loading is provided by reverse biased Schottky barrier diodes respectively connected between said transistors and an applied first predetermined voltage (Vdd).

According to another aspect of the present invention there is provided a method of forming the memory cell in a semiconductor substrate, comprising the steps of:

forming first and second transistors and a pass transistor connected to the first transistor or the second transistor in said semiconductor substrate;

forming a tank region of a first conductivity type in said semiconductor substrate;

forming a metal layer over said semiconductor substrate; and

etching said metal layer to form Schottky diodes in conjunction with said tank region, and to form interconnects between said Schottky diodes and said first and second transistors,

providing connections between the first transistor and the second transistor to form a latching circuit, providing power supply connections to the Schottky diodes as loads of the first and second transistors and providing a word line and a bit line connected to said pass transistor.

A memory cell of the present invention uses a reverse biased Schottky diode to provide a high resistance between a pair of latching transistors and $V_{dd}$. The Schottky diodes are operable to assume an effective resistance in excess of 500 gigaohms at five volts, and the resistance provided by the reverse biased Schottky diodes may be adjusted by providing a doped region at the metal/semiconductor interface. By varying the metal used to form the diode, a wide range of effective resistances may be obtained.

This aspect of the present invention provides a technical advantage that a large resistance can be provided in a very small surface area, thus enabling higher density memory arrays. Furthermore, the present invention provides for a large resistance having a value which can be accurately controlled.

In another aspect of the present invention, the metal silicide used to form the Schottky diode is also used to form the local interconnect structure. This provides the technical advantage that the resistive load can be formed without additional lithographic steps.

## BRIEF DESCRIPTION OF THE DRAWINGS

For a more complete understanding of the present invention and the advantages thereof, reference is now made to the following description taken in conjunction with the accompanying drawings in which:

FIGURE 1 illustrates a circuit diagram of a memory cell of the present invention, using reverse biased Schottky diodes as resistive elements;

FIGURE 2 illustrates a first stage in forming the Schottky barrier load;

FIGURE 3 illustrates a second stage in forming the Schottky barrier load;

FIGURE 4 illustrates a third stage in forming the Schottky barrier load; and

FIGURE 5 shows a fourth stage in forming the Schottky barrier load.

## DETAILED DESCRIPTION OF THE INVENTION

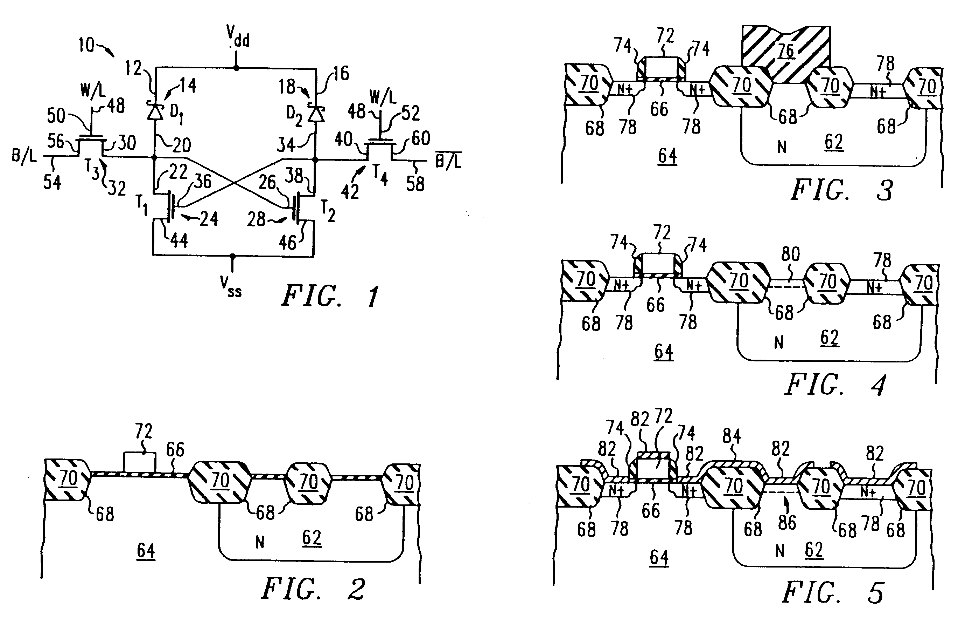

For a more complete understanding of the present invention, reference is now made to FIGUREs 1-5 of the drawings, like numerals being used for like and corresponding parts of the various drawings.

FIGURE 1 illustrates a circuit diagram of the memory cell of the present invention. The memory cell 10 has a high voltage source, $V_{dd}$, generally five volts, connected to the anode 12 of a first Schottky diode 14 and to the anode 16 of a second Schottky diode 18. The cathode 20 of the first Schottky diode 14 is connected to the drain 22 of a first transistor 24, to the gate 26 of a second transistor 28, and to the source 30 of a third transistor 32. The cathode 34 of the second Schottky diode 18 is connected to base 36 of the first transistor 24, to the drain 38 of the second transistor 28 and to the source 40 of a fourth transistor 42. A low voltage source, $V_{ss}$, generally at ground voltage, is connected to the sources 44 and 46 of the first and second transistors 24 and 28, respectively. A word line 48 is connected to the gates 50 and 52 of the third and fourth transistors 32 and 42, respectively. A bit line 54 is connected to the drain 56 of the third transistor 32 and an inverted bit line 58 is connected to the drain 60 of the fourth transistor 42.

In operation, the memory cell 10 is part of a memory array of similarly designed memory cells. Although the active switching elements of the memory cell 10 are shown as NMOS transistors, a similar memory cell could be constructed using P-channel MOS transistors or bipolar transistors.

In the memory cell 10, third and fourth transistors 32 and 42 operate as transfer gates which serve isolate or connect the outputs of the cell with the bit line 54 and inverted bit line 58. These transistors are turned on and off by the word line 48, which selects a memory cell 10 for reading or writing When the word lines 48 are turned on (a logical high voltage), the third and fourth transistors 32 and 42 are operable to conduct a current between their respective drains and sources.

To write data into the cell, the word line 48 is turned on to enable the third and fourth transistors 32 and 42 to conduct. Assuming a bit line value of one (a logical high voltage), and hence a inverted bit line value of zero, the first transistor 24 would be turned off and the second transistor 28 would be turned on. Hence, the drain 38 of the second transistor 28 would be connected to $V_{ss}$, while the drain 22 of the first transistor 24 would be connected to the logical high voltage at the bit line 54. When the third and fourth transistors 32 and 42 are turned off, the memory cell 10 will remain in this state, holding the data therein.

To read the cell, the word line 48 is again turned on allowing conduction from the drains 22 and 38 to the bit line 54 and noninverting bit line 58, respectively. A sense amplifier (not shown) is connected to the bit line 54 and inverted bit line 58 to read the status of the voltages at the drains 22 and 38. A logic level representing the data held in the cell is produced at the output of the sense amplifier.

The diodes 14 and 18 are used as load resistors for the first and second transistors 24 and 28. The effective resistance of the reversed bias diodes 14 and 18 directly effects the transfer of standby power to the SRAM. A Schottky diode, when reverse biased, behaves somewhat like a regular P/N junction except for its higher leakage current. The leakage of the Schottky is a function of the intrinsic barrier between metal and silicon and of a function of the electric field (or voltage) across the barrier. The equation describing the leakage current density of a reverse biased junction, for a reverse voltage, $V_r$, being greater than $3kT/q$ ($kT/q = 0.026V$ as room temperature), is given by:

$$J_r = AT^2 \exp(-qE_0/kT) \exp[+q(qF/4\pi e_s)^{1/2}/kT]$$

where

    A =     Richardson constant

    T =     Temperature

EO = Barrier height or difference between metal work function and silicon electron affinity

F = Electric field intensity

$e_s$ = Dielectric constant of silicon

Thus, it is possible to select a specific metal, with a corresponding barrier height, such that the effective resistance at $V_r$ equals five volts is within the desired range.

Table I lists barrier heights for some common silicides.

TABLE I

| SILICIDE | BARRIER HEIGHT |
|---|---|
| TiSi2 | 0.60 V |
| CoSi2 | 0.64 V |
| CrSi2 | 0.57 V |
| MoSi2 | 0.55 V |
| TaSi2 | 0.59 V |
| WSi2 | 0.65 V |

The barrier heights of the silicides listed in Table I may be adjusted slightly by varying the electric field. The electric field may be varied either with a bias or by introducing a thin layer of semiconductor material with a controllable of number of dopants on a semiconductor surface, for example, by ion implantation as is shown in connection with FIGURE 4. Typically, the effective barrier of the reverse biased Schottky diode may be reduced by 0.2 volts in silicon and by over 0.3 Volts in gallium arsenide.

For example, $TiSi_2$ could be used to form a Schottky barrier used for a resistance load in an SRAM cell. The intrinsic barrier height of $TiSi_2$ is 0.6 volts and the reverse leakage current density, $J_r$, could be calculated from the equation above to be approximately $1 \times 10^{-3}$ amps/cm$^2$.

Using a contact of one micrometer by one micrometer, the leakage current will be approximately $1 \times 10^{-11}$ amps. At five volts, the equivalent resistance will be equal to 500 gigaohms. By a slight reduction of barrier height to 0.56 volts, the resistance will be equal to approximately 100 gigaohms at five volts for the same area of contact. The barrier height could be reduced, for example, by an implantation of arsenic at a concentration of approximately $2 \times 10^{12}$ ions/cm$^2$. Alternatively, as is shown in Table I, $MoSi_2$ could be used to form a Schottky barrier with a barrier height of 0.56 volts, in which case no implant would be required.

Referring now to FIGURE 2, the process for forming a Schottky diode in conjunction with a MOS transistor is illustrated. A N tank region 62 is formed in a P- silicon substrate 64. Isolation regions 68 are formed with oxide 70, using a LOCOS (local oxidation of silicon) process or other well known techniques.

A doped polysilicon gate 72 is formed on the gate oxide layer 66 above the substrate 64. It should be noted that if a CMOS periphery is used in the memory device, the N tank region may be formed as part of the normal process; therefore, it will not require an additional masking step.

Referring now to FIGURE 3, a second stage in forming the Schottky diode is illustrated. Sidewall oxide regions 74 are formed on the doped polysilicon gate 72, and the remaining gate oxide layer 66 not covered by the doped polysilicon gate 72 or the sidewall oxide regions 74 is removed using a suitable etch, such as a $CHF_3 + C_2F_6$ plasma etch. A photoresist mask 76 is formed over the area to be used for the Schottky load, and N+ source/drain regions 78 are formed by implantation on the exposed silicon substrate 64 and N tank 62.

Referring to FIGURE 4, a third stage in the process of the present invention is illustrated. The photoresist mask 76 is removed and the barrier height adjustment implant is performed, if necessary. If the barrier height adjustment implant is performed. a doped region 80 is formed where the Schottky diode is to be placed. Since the energy and dose necessary to perform the barrier height adjustment implant are relatively small, it is not necessary to mask the other active areas while performing the implant.

In FIGURE 5, a fourth stage in forming the Schottky diode is illustrated, using a $TiSi_2$ layer to form the Schottky diode and local interconnect. A layer of Ti is deposited on the surface of the device. By heating the device to approximately 675° C. in a furnace, the Ti reacts with the silicon to form $TiSi_2$ regions 82. However, over the field oxide 70, TiN regions 84 are formed The $TiSi_2$ regions 82 and TiN regions 84 are patterned and etched to form the local interconnect structure. A Schottky diode 86 is formed between the N tank 62 and the $TiSi_2$ layer 82 thereabove.

The TiN by-product may be removed using a solution of $NH_4OH$, or other suitable etch. Since it is desirable to maintain an interconnect between the Schottky diode 86 and one of the N+ source/drain regions 78, the TiN region 84 therebetween should be masked prior to performing the TiN etch.

As can be seen, the present invention provides the technical advantage that a very large resistive load is produced in a very small area. Furthermore, the resistive load may be accurately trimmed by doping the area of the N tank region 62 which is to be used to form the Schottky diode 86. The present invention also provides the technical advantage that the diode can be formed in conjunction with processing steps used to form other regions of the memory device; thus, the complexity of forming the device is not increased.

**Claims**

1. A static memory cell comprising;
   a pass transistor (32) responsive to a word line (48) signal through which the state of the memory cell is communicated with a bit line (54);
   a latching circuit including loaded and cross-coupled first and second transistors (24,28) for latching a data bit to be stored in the memory cell; and
   characterised in that
   loading is provided by reverse biased Schottky barrier diodes (14,18) respectively connected between said transistors and an applied first predetermined voltage (Vdd).

2. A memory cell according to claim 1 wherein each of said Schottky barrier diodes (14,18) comprises a semiconductor region (62) of a first conductivity type and a metal region (82) in contact with said semiconductor region.

3. A memory cell according to claim 2 wherein said metal region (82) comprises a metal silicide.

4. A memory cell according to claim 3 wherein said metal silicide (82) comprises titanium silicide.

5. A memory cell according to claim 2, 3 or 4 wherein each of said Schottky barrier diodes (14,18) further comprises a doped region (80) in said semiconductor region (62) for adjusting the height of the Schottky barrier.

6. A memory cell according to any preceding claim and wherein said first transistor (24) is driven by said bit line (54) and said second transistor (28) is driven by an inverted bit line (58).

7. A memory cell as claimed in any of claims 2 to 6 wherein said metal region comprises a titanium compound.

8. A memory cell as claimed in any of claims 2 to 7 wherein an extension of said metal regions connects said Schottky diode to said latching circuit.

9. A memory cell as claimed in claim 8 and wherein said extension comprises titanium nitride.

10. A memory cell as claimed in claim 9 and wherein said metal region comprises titanium silicide.

11. A method of forming a memory cell of any preceding claim in a semiconductor substrate (64), comprising the steps of:
    forming first and second transistors (24,28) and a pass transistor (32,42) connected to the first transistor or the second transistor in said semiconductor substrate;
    forming a tank region (62) of a first conductivity type in said semiconductor substrate;
    forming a metal layer (82) over said semiconductor substrate; and
    etching said metal layer to form Schottky diodes (14,18) in conjunction with said tank region, and to form interconnects between said Schottky diodes and said first and second transistors,
    providing connections between the first transistor and the second transistor to form a latching circuit, providing power supply connections to the Schottky diodes as loads of the first and second transistors and providing a word line (48) and a bit line (54,58) connected to said pass transistor (32,42).

12. A method according to claim 11 and further comprising forming a doped region (80) at the surface of said tank region such that the barrier height of the Schottky diodes is reduced.

**13.** A method according to claim 11 wherein said metal layer comprises titanium and said semiconductor comprises silicon and further comprising the step of heating the titanium to form titanium silicide over regions of the semiconductor surface.

**14.** A method according to claim 11 comprising the further steps of:

forming an oxide region (70) separating the surface of said tank region from the surface of said substrate;

heating said metal layer to create a reaction between said metal layer and said substrate and tank regions such that a metal silicide region is formed in place of said metal region;

masking said insulating regions to define interconnects between said Schottky diodes and said first and second transistors; and

etching unmasked portions of the metal on said insulating region.

**Patentansprüche**

**1.** Statische Speicherzelle mit

einem auf ein Signal einer Wort-Leitung (48) ansprechenden Übertragungstransistor (32), durch den der Zustand der Speicherzelle mit einer Bit-Leitung (54) in Verbindung gebracht wird, und

einem Verriegelungsschaltkreis, der gespeiste und kreuzgekoppelte erste und zweite Transistoren (24, 28) zum Verriegeln eines in der Speicherzelle zu speichernden Datenbits enthält,

dadurch gekennzeichnet, daß

die Speisung durch in Sperrichtung vorgespannte Schottky-Dioden (14, 18) erfolgt, die zwischen die Transistoren und eine angelegte erste vorbestimmte Spannung (Vdd) geschaltet sind.

**2.** Speicherzelle nach Anspruch 1, bei der jede der Schotty-Dioden (14, 18) eine Halbleiterzone (62) von einem ersten Leitfähigkeitstyp und eine Metallzone (82) enthält, die mit der Halbleiterzone in Kontakt ist.

**3.** Speicherzelle nach Anspruch 2, bei der die Metallzone (82) ein Metallsilicid enthält.

**4.** Speicherzelle nach Anspruch 3, bei der das Metallsilicid (82) ein Titansilicid enthält.

**5.** Speicherzelle nach Anspruch 2, 3 oder 4, bei der jede der Schottky-Dioden (14, 18) eine dotierte Zone (80) in der Halbleiterzone (62) enthält, um die Höhe der Schottky-Barriere einzustellen.

**6.** Speicherzelle nach einem der vorhergehenden Ansprüche, bei der der erste Transistor (24) von der Bit-Leitung (54) und der zweite Transistor (58) von einer invertierten Bit-Leitung (58) getrieben ist.

**7.** Speicherzelle nach einem der Ansprüche 2 bis 6, bei der die Metallzone eine Titanverbindung enthält.

**8.** Speicherzelle nach einem der Ansprüche 2 bis 7, bei der eine Erweiterung der Metallzonen die Schottky-Diode mit dem Verriegelungs-Schaltkreis verbindet.

**9.** Speicherzelle nach Anspruch 8, bei der die Erweiterung Titannitrid enthält.

**10.** Speicherzelle nach Anspruch 9, bei der die Metallzone Titansilicid enthält.

**11.** Verfahren zur Bildung einer Speicherzelle nach einem der vorhergehenden Ansprüche in einem Halbleitersubstrat (64), das die folgenden Schritte aufweist:

Bilden erster und zweiter Transistoren (24, 28) und eines Übertragungstransistors (32, 42), der mit dem ersten Transistor oder dem zweiten Transistor verbunden ist, in dem Halbleitersubstrat,

Bilden einer Wannenzone (62) von einem ersten Leitfähigkeitstyp in dem Halbleitersubstrat,

Bilden einer Metallschicht (82) über dem Halbleitersubstrat,

Ätzen der Metallschicht zur Bildung von Schottky-Dioden (14, 18) in Verbindung mit der Wannenzone und zur Bildung von Zwischenverbindungen zwischen den Schottky-Dioden und den ersten und zweiten Transistoren, und

Schaffen von Verbindungen zwischen dem ersten Transistor und dem zweiten Transistor zur Bildung eines Verriegelungsschaltkreises, Schaffen von Stromversorgungs-Verbindungen zu den

6

Schottky-Dioden zur Speisung der ersten und zweiten Transistoren und Schaffen einer Wort-Leitung (48) und einer Bit-Leitung (54, 58), die mit dem Transistor (32, 42) verbunden sind.

12. Verfahren nach Anspruch 11, bei dem überdies eine dotierte Zone (80) an der Oberfläche der Wannenzone so gebildet wird, daß die Höhe der Barriere der Schottky-Dioden verringert wird.

13. Verfahren nach Anspruch 11, bei dem die Metallschicht Titan und der Halbleiter Silizium enthält, und das überdies den Schritt eines Erhitzens des Titaniums erhält, um über Zonen der Halbleiteroberfläche Titaniumsilicid zu bilden.

14. Verfahren nach Anspruch 11, das überdies die folgenden Schritte enthält:
    Bilden einer Oxidzone (70), die die Oberfläche der Wannenzone von der Oberfläche des Substrats trennt,
    Erhitzen der Metallschicht, um eine solche Reaktion zwischen der Metallschicht und dem Substrat und Wannenzonen herbeizuführen, daß anstelle der Metallzone eine Metallsilicidzone gebildet wird,
    Maskieren der Isolierzonen, um Zwischenverbindungen zwischen den Schottky-Dioden und den ersten und zweiten Transistoren festzulegen, und
    Ätzen nicht maskierter Abschnitte des Metalls auf der Isolierzone.

**Revendications**

1. Cellule de mémoire statique comprenant:
    un transistor de passage (32) sensible à un signal de ligne de mots (48) par l'intermédiaire duquel l'état de la cellule de mémoire communique avec une ligne de bits (54);
    un circuit de verrouillage comprenant des premier et second transistors (24, 28) chargés et à couplage croisé pour verrouiller un bit de donnée à stocker dans la cellule de mémoire;
    caractérisé en ce que
    la charge est assurée par des diodes (14, 18) à barrière de Schottky à polarisation inverse, respectivement connectées entre lesdits transistors et une première tension prédéterminée appliquée (Vdd).

2. Cellule de mémoire selon la revendication 1, dans laquelle chacune desdites diodes (14, 18) à barrière de Schottky comporte une région semiconductrice (62) d'un premier type de conductivité et une région métallique (82) en contact avec ladite région semiconductrice.

3. Cellule de mémoire selon la revendication 2, dans laquelle ladite région métallique (82) comporte un siliciure de métal.

4. Cellule de mémoire selon la revendication 3, dans laquelle ledit siliciure de métal (82) comporte du siliciure de titane.

5. Cellule de mémoire selon la revendication 2, 3 ou 4, dans laquelle chacune desdites diodes (14, 18) à barrière de Schottky comporte en outre une région dopée (80) dans ladite région semiconductrice (62) pour régler la hauteur de la barrière de Schottky.

6. Cellule de mémoire selon l'une quelconque des revendications précédentes, dans laquelle ledit premier transistor (24) est commandé par ladite ligne de bits (54) et ledit second transistor (28) est commandé par une ligne de bits inversée (58).

7. Cellule de mémoire selon l'une quelconque des revendications 2 à 6, dans laquelle ladite région métallique comporte un composé de titane.

8. Cellule de mémoire selon l'une quelconque des revendications 2 à 7, dans laquelle un prolongement desdites régions métalliques relie la diode de Schottky audit circuit de verrouillage.

9. Cellule de mémoire selon la revendication 8, dans laquelle ledit prolongement comporte du nitrure de titane.

**10.** Cellule de mémoire selon la revendication 9, dans laquelle ladite région métallique comporte du siliciure de titane.

**11.** Procédé de formation d'une cellule de mémoire selon l'une quelconque des revendications précédentes, dans un substrat semiconducteur (64), comprenant les étapes de:

formation d'un premier et d'un second transistors (24, 28) et d'un transistor de passage (32, 42) reliés au premier transistor ou au second transistor dans ledit substrat semiconducteur;

formation d'une région de puits (62) d'un premier type de conductivité dans ledit substrat semiconducteur;

formation d'une couche métallique (82) sur ledit substrat semiconducteur; et

attaque de ladite couche métallique pour former des diodes de Schottky (14, 18) en conjonction avec ladite région de puits, et pour former des interconnexions entre lesdites diodes de Schottky et lesdits premier et second transistors,

réalisation de connexions entre le premier transistor et le second transistor pour former un circuit de verrouillage réalisation de connexions d'alimentation pour les diodes de Schottky comme charges des premier et second transistors et réalisation d'une ligne de mots (48) et d'une ligne de bits (54, 58) connectées audit transistor de passage (32, 42).

**12.** Procédé selon la revendication 11, et comprenant en outre la formation d'une région dopée (80) à la surface de ladite région de puits de telle sorte que la hauteur de la barrière des diodes de Schottky soit réduite.

**13.** Procédé selon la revendication 11, dans lequel ladite couche métallique comporte du titane et ledit semiconducteur comporte du silicium, et ledit procédé comporte en outre l'étape de chauffage du titane pour former du siliciure de titane sur des régions de la surface du semiconducteur.

**14.** Procédé selon la revendication 11 comprenant en outre les étapes suivantes:

formation d'une région d'oxyde (70) séparant la surface de ladite région de puits de la surface dudit substrat;

chauffage de ladite couche métallique pour créer une réaction entre ladite couche métallique et ledit substrat et les régions de puits de telle sorte qu'une région de siliciure métallique soit formée à la place de ladite région métallique;

masquage desdites régions isolantes pour définir des interconnexions entre lesdites diodes de Schottky et lesdits premier et second transistors; et

attaque des parties non masquées du métal sur ladite région isolante.

FIG. 1

FIG. 2

FIG. 3

FIG. 4

FIG. 5